# EUROPÄISCHE PATENTANMELDUNG

(11) **EP 0 856 941 A1**
(43) Veröffentlichungstag der Anmeldung: **05.08.1998**
(21) Anmeldenummer: 97118869.3
(22) Anmeldetag: 30.10.1997
(51) Int. Cl.: H03D 13/00

(54) **Abtast-Phasendetektor**

(30) Priorität: 03.02.1997 DE 19703889
(71) Anmelder: ROBERT BOSCH GMBH, 70442 Stuttgart (DE)
(72) Erfinder: Brauns, Herbert, 71522 Backnang (DE)

(57) **Zusammenfassung**

Ein Abtast-Phasendetektor, dessen Ausgangssignal (fd) sehr breitbandig ist und einen sehr ebenen Frequenzgang aufweist, besitzt eine Schaltspeicherdiode (SRD), zu der über Koppelkondensatoren (Ck1, Ck2) eine Serienschaltung von mindestens zwei Dioden (D1, D2) parallel geschaltet ist. Über ein R/C-Netzwerk (R1, R2, C3, C4) wird den Dioden (D1, D2) ein Eingangssignal (fo) zugeführt und ein Ausgangssignal (fd) abgegriffen, das der Phasenablage zwischen dem Eingangssignal (fo) und einem Referenzsignal (fr) entspricht. Das Referenzsignal (fr) wird der Schaltspeicherdiode (SRD) von einem Symmetriertransformator (Tr) zugeführt. In die Zuleitungen vom Symmetriertransformator (Tr) zu der Schaltspeicherdiode (SRD) sind Entkopplungswiderstände (Rs1, Rs2) eingefügt, welche störende Resonanzen oder Reflexionen des Symmetriertransformators (Tr) bedämpfen.

## Beschreibung

### Stand der Technik

Die vorliegende Erfindung betrifft einen Abtast-Phasendetektor, bestehend aus einer Schaltspeicherdiode, zu der über Koppelkondensatoren eine Serienschaltung von mindestens zwei Dioden parallel geschaltet ist, wobei ein Symmetriertransformator vorgesehen ist, welcher der Schaltspeicherdiode ein Referenzsignal zuführt, und über ein Entkopplungsnetzwerk den Dioden ein Eingangssignal zuführbar und ein Ausgangssignal abgreifbar ist, das der Phasenablage zwischen dem Eingangssignal und dem Referenzsignal entspricht.

Ein derartiger Abtast-Phasendetektor ist aus dem Product Catalog der Firma Alpha Industries INC, 1994, S. 4-22 bekannt. Die Kernteile dieses Abtast-Phasendetektors, das sind die Schaltspeicherdiode (Step-Recovery-Diode) und ein damit über Koppelkondensatoren verbundenes Diodenpaar, sind gemeinsam auf einem Substrat in Schichtschaltungstechnik aufgebracht. Alle anderen Schaltungsteile, welche der Zuführung eines Eingangssignals, eines Referenzsignals und der Ableitung eines Ausgangssignals dienen, sind über Leitungen mit den auf dem Substrat befindlichen Dioden verbunden. Das Ausgangssignal dieser bekannten Schaltung zeigt eine relativ starke Frequenzabhängigkeit, und die Schaltung ist auch nicht sehr breitbandig.

Der Erfindung liegt daher die Aufgabe zugrunde, einen Abtast-Phasendetektor der eingangs genannten Art anzugeben, dessen Ausgangssignal über ein möglichst breites Frequenzband (2 bis 30 GHz) einen glatten Frequenzgang aufweist.

### Vorteile der Erfindung

Erfindungsgemäß wird die genannte Aufgabe mit den Merkmalen des Anspruchs 1 dadurch gelöst, daß in die Zuleitungen vom Symmetriertransformator zu der Schaltspeicherdiode Entkopplungswiderstände eingefügt sind, welche so groß gewählt sind, daß sie störende Resonanzen oder Reflexionen zwischen dem Symmetriertransformator und der Schaltspeicherdiode bedämpfen.

Gemäß den Unteransprüchen ist es zweckmäßig, nicht nur die Dioden und die Koppelkondensatoren sondern auch die Entkopplungswiderstände und ein mit einem Lastwiderstand beschaltetes L/C-Netzwerk zur Aufladung der Schaltspeicherdiode auf einem gemeinsamen Substrat in Schichtschaltungstechnik aufzubringen. Dadurch werden Zuführungsleitungen zu den Dioden extrem kurz, was einem sehr breitbandigen Betrieb des Abtast-Phasendetektors entgegenkommt. Weitere Widerstände, welche die Dioden beeinflussende Störimpulse bedämpfen, können ebenfalls auf dem Substrat aufgebracht sein.

### Beschreibung eines Ausführungsbeispiels

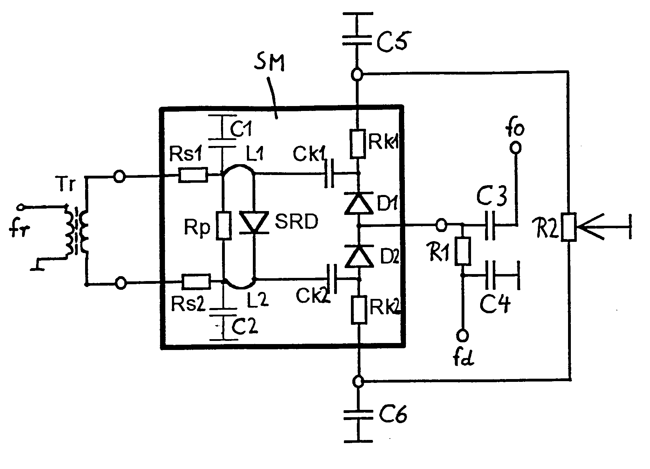

Anhand eines in der Zeichnung dargestellten Ausführungsbeispiels wird nachfolgend die Erfindung näher erläutert.

Die in der einzigen Figur gezeigte Schaltung, ist ein Abtast-Phasendetektor, wie er z.B. in Phasenregelkreisen (PLL) einsetzbar ist.

Kernstück des Abtast-Phasendetektors ist ein in der Zeichnung dick umrandetes Modul SM, vorzugsweise ein Keramiksubstrat, auf dem die Schaltelemente in Schichtschaltungstechnik (Dick- oder Dünnschichttechnik) aufgebracht sind. Das Modul SM weist eine Schaltspeicherdiode (Step-Recovery-Diode) SRD auf, die über zwei gleichgroße Koppelkondensatoren Ck1 und Ck2 mit einem Paar in Reihe geschalteter Dioden D1 und D2 parallel geschaltet ist.

Die Schaltspeicherdiode SRD wird von einem Referenzsignal fr angesteuert. Dabei gelangt das Referenzsignal fr über einen Symmetriertransformator Tr an die Schaltspeicherdiode SRD. Die Schaltspeicherdiode SRD ist an seinen beiden Anschlüssen mit einem L/C-Netzwerk L1, C1 und L2, C2 beschaltet. In jeder Periode des Referenzsignals fr nimmt die Schaltspeicherdiode SRD Ladung auf, wobei das L/C-Netzwerk L1, C1 und L2, C2 einen sehr kurzen Ladespannungsimpuls erzeugt.

In die Zuleitungen vom Symmetriertransformator Tr zur Schaltspeicherdiode SRD sind gleichgroße Entkopplungswiderstände Rs1 und Rs2 eingefügt. Diese Entkopplungswiderstände Rs1 und Rs2 sind gerade so groß, daß Resonanzen durch parasitäre Elemente des Symmetrierübertragers Tr sowie Mehrfachreflexionen der Schaltimpulse zwischen der Schaltspeicherdiode SRD und dem Symmetrierübertrager Tr ausreichend bedämpft werden. Die Entkopplungswiderstände Rs und Rs2 sind aber so klein, daß die niedrige Impedanz der Schaltspeicherdiode SRD nur unwesentlich vergrößert wird. Die erforderliche Steuerleistung des Referenzsignals fr steigt dadurch nur minimal an. Die beschriebenen Entkopplungswiderstände Rs1 und Rs2 sorgen also dafür, daß es nicht zu störenden Frequenzeinbrüchen im Frequenzgang des Ausgangssignals fd kommt.

Die beiden L-C-Glieder L1, C1 und L2, C2 sind an einen gemeinsamen Lastwiderstand Rp angeschlossen. Durch die nichtlineare Sperrschichtkapazität der Schaltspeicherdiode SRD können im Zusammenwirken mit anderen Schaltungsteilen Schwingungen mit unerwünschten Frequenzen entstehen. Solche Störresonanzen werden durch den Lastwiderstand Rp bedämpft.

Jedes Mal, wenn die Schaltspeicherdiode eine Ladung je Periode des Referenzsignals fr aufgenommen hat, folgt ein sehr schneller Entladungsimpuls, der über die Koppelkondensatoren Ck1, Ck2 an das Diodenpaar D1 und D2 weitergeleitet wird. Dieser Entladeimpuls schaltet das Diodenpaar D1, D2 durch. Statt eines Diodenpaares kann auch eine aus mehr als zwei Dioden bestehende Diodenanordnung vorgesehen werden. Durch diesen Schaltvorgang der Dioden D1 und D2 wird der Phasenzustand eines ebenfalls an den Dioden D1 und D2 anliegenden Eingangssignals fo abgetastet. Entsprechend der Phasenablage zwischen dem Eingangssignal fo und dem Referenzsignal fr lädt oder entlädt sich ein an die Dioden angeschlossenes R/C-Netzwerk R1, R2, C3, C4. Das zwischen dem Widerstand R1 und der Kapazität C4 abgegriffene Ausgangssignal fd ist ein Gleichspannungssignal, das der genannten Phasenablage entspricht. Das R/C-Netzwerk R1, R2, C3, C4 entkoppelt das Ausgnagssignal fd von dem Eingangssignal fo.

Die symmetrisch an beiden Enden des Diodennetzwerkes D1, D2 angeschlossenen R/C-Glieder Rk1, C5 und Rk2, C6 wirken als Tiefpaßfilter, über welche die Richtspannungen an den Dioden D1, D2 ausgekoppelt wird. Damit die Schaltimpulse von der Schaltspeicherdiode SRD unbeeinflußt (von Leitungskapazitäten oder Pulsreflexionen) das Diodenpaar D1, D2 durchschalten kann, ist es zweckmäßig, die Widerstände Rk1 und Rk2 mit ganz kurzen Leitungslangen an die Dioden D1 und D2 anzuschließen. Der zu dem Diodenpaar D1, D2 parallel geschaltete veränderbare Widerstand R2 dient dazu, die Spannungen an den Dioden D1, D2 symmetrisch zu machen.

Wie der Zeichnung zu entnehmen ist, sind außer den Dioden SRD, D1, D2, und den Koppelkondensatoren Ck1, Ck2 auch das L/C-Netzwerk L1, C1; L2, C2, und die Widerstände Rs1, Rs2, Rk1, Rk2 auf dem Modul SM integriert. Dadurch ergeben sich extrem kurze Leitungsverbindungen und damit sehr kleine Leitungsinduktivitäten und -kapazitäten. Soll die Schaltung im GHz-Bereich von 2 bis 30 GHz betrieben werden, so wirken sich diese kleinen Blindwiderstände dahingehend aus, daß der Frequenzgang des Ausgangssignals fd einen sehr glatten Verlauf hat und das über ein weites Frequenzband.

## Patentansprüche

1. Abtast-Phasendetektor, bestehend aus einer Schaltspeicherdiode, zu der über Koppelkondensatoren eine Serienschaltung von mindestens zwei Dioden parallel geschaltet ist, wobei ein Symmetriertransformator vorgesehen ist, welcher der Schaltspeicherdiode ein Referenzsignal zuführt, und über ein Entkopplungsnetzwerk den Dioden ein Eingangssignal zuführbar und ein Ausgangssignal abgreifbar ist, das der Phasenablage zwischen dem Eingangssignal und dem Referenzsignal entspricht, dadurch gekennzeichnet,
daß in die Zuleitungen vom Symmetriertransformator (Tr) zu der Schaltspeicherdiode (SRD) Entkopplungswiderstände (Rs1, Rs2) eingefügt sind, welche so groß gewählt sind, daß sie störende Resonanzen oder Reflexionen zwischen dem Symmetriertransformator (Tr) und der Schaltspeicherdiode (SRD) bedämpfen.

2. Abtast-Phasendetektor nach Anspruch 1, dadurch gekennzeichnet, daß die Schaltspeicherdiode (SRD) mit einem L/C-Netzwerk (L1, C1; L2, C2) beschaltet ist und daß das L/C-Netzwerk einen Lastwiderstand (Rp) aufweist.

3. Abtast-Phasendetector nach Anspruch 1, dadurch gekennzeichnet, daß an den Verbindungspunkten zwischen den Koppelkondensatoren (Ck1, Ck2) und den Dioden (D1, D2) Widerstände (Rk1, Rk2) angeschlossen sind.

4. Abtast-Phasendetektor nach den Ansprüchen 1 und 2, dadurch gekennzeichnet, daß neben der Schaltspeicherdiode (SRD), den Dioden (D1, D2) und den Koppelkondensatoren (Ck1, Ck2) auch die Entkopplungswiderstände (Rs1, Rs2) und das L/C-Netzwerk (L1, C1; L2, C2) einschließlich des Lastwiderstandes (Rp) in Schichtschaltungstechnik auf einem gemeinsamen Substrat (SM) aufgebracht sind.

5. Abtast-Phasendetektor nach den Ansprüchen 3 und 4, dadurch gekennzeichnet, daß sich auf dem Substrat (SM) zusätzlich die Widerstände (Rk1, Rk2) befinden, welche an den Verbindungspunkten zwischen den Koppelkondensatoren (Ck1, Ck2) und den Dioden (D1, D2) angeschlossen sind.
